# EUROPÄISCHE PATENTSCHRIFT

(11) **EP 3 863 961 B1**
(45) Veröffentlichungstag und Bekanntmachung des Hinweises auf die Patenterteilung: **09.08.2023**
(21) Anmeldenummer: 19783524.2
(22) Anmeldetag: 07.10.2019
(51) Int. Cl.: B81B 7/00, G01S 7/481, G01S 17/93, G02B 26/08, G02B 26/10

(54) **VERFAHREN ZUR STEUERUNG EINER ANTRIEBSEINRICHTUNG EINES MIKROSCHWINGSPIEGELS, STEUERVORRICHTUNG UND UMLENKSPIEGELEINRICHTUNG**
METHOD OF CONTROLLING A RESONANT MICRO-MIRROR, CONTROL APPARATUS AND RESONANT MICRO-MIRROR
RÉGULATION D'UN MICRO-MIROIR RÉSONANT, DISPOSITIF DE RÉGULATION ET MICRO-MIROIR RÉSONANT

(30) Priorität: 10.10.2018 DE 102018124964
(43) Veröffentlichungstag der Anmeldung: 18.08.2021
(73) Patentinhaber: Valeo Schalter und Sensoren GmbH, 74321 Bietigheim-Bissingen (DE)
(72) Erfinder: SCHENK, Jochen, 74321 Bietigheim-Bissingen (DE); KLEISER, Michael, 74321 Bietigheim-Bissingen (DE); NIES, Jürgen, 74321 Bietigheim-Bissingen (DE); SELBMANN, Frank, 74321 Bietigheim-Bissingen (DE); MÜLLER, Felix, 74321 Bietigheim-Bissingen (DE)
(74) Vertreter: Pothmann, Karsten
(86) Internationale Anmeldenummer: PCT/EP2019/077028
(87) Internationale Veröffentlichungsnummer: WO 2020/074416

(56) Entgegenhaltungen:
- DE-A1-102009 058 762
- US-A1- 2010 043 551
- MOORE STEVEN IAN ET AL: "A switched actuation and sensing method for a MEMS electrostatic drive", 2016 AMERICAN CONTROL CONFERENCE (ACC), AMERICAN AUTOMATIC CONTROL COUNCIL (AACC), 6. Juli 2016 (2016-07-06), Seiten 5817-5822, XP032933597, DOI: 10.1109/ACC.2016.7526581 [gefunden am 2016-07-29]

## Beschreibung

### Technisches Gebiet

Die Erfindung betrifft ein Verfahren nach Anspruch 1 zur Steuerung einer Antriebseinrichtung eines Mikroschwingspiegels, wobei die Antriebseinrichtung wenigstens zwei Kammantriebe aufweist, welche auf unterschiedlichen radialen Seiten einer Schwenkachse des Mikroschwingspiegels angeordnet sind, wobei bei dem Verfahren
- wenigstens zwei Ansteuersignale erzeugt und damit die wenigstens zwei Kammantriebe wenigstens zeitweise so angesteuert werden, dass diese den Mikroschwingspiegel schwingend antreiben,
- wenigstens ein die Elongation des Mikroschwingspiegels charakterisierendes Elongationssignal mithilfe wenigstens eines Kammantriebs erzeugt wird,
- wenigstens eines der Ansteuersignale auf Basis wenigstens eines der Elongationssignale an die Schwingung des Mikroschwingspiegels angepasst wird.

Ferner betrifft die Erfindung eine Steuervorrichtung nach Anspruch 9 zur Steuerung wenigstens einer Antriebseinrichtung eines Mikroschwingspiegels, wobei die wenigstens eine Antriebseinrichtung wenigstens zwei Kammantriebe aufweist, welche auf unterschiedlichen radialen Seiten einer Schwenkachse des Mikroschwingspiegels angeordnet sind,
- mit wenigstens einer Ansteuereinrichtung zur Ansteuerung der wenigstens zwei Kammantriebe mithilfe von Ansteuersignalen,
- mit wenigstens einer Elongationserfassungseinrichtung, mit welcher wenigstens ein die Elongation des Mikroschwingspiegels charakterisierendes Elongationssignal ermittelt werden kann,
- und mit wenigstens einer Einrichtung, welche mit der wenigstens einen Ansteuereinrichtung regelbar so verbunden ist, dass wenigstens eines der Ansteuersignale auf Basis wenigstens eines der Elongationssignale an die Schwingungsfrequenz des Mikroschwingspiegels angepasst werden kann.

Außerdem betrifft die Erfindung eine Umlenkspiegeleinrichtung einer optischen Detektionsvorrichtung nach Anspruch 11 mit
- wenigstens einem Mikroschwingspiegel,
- wenigstens einer Antriebseinrichtung für den wenigstens einen Mikroschwingspiegel, wobei die Antriebseinrichtung wenigstens zwei Kammantriebe aufweist, welche auf unterschiedlichen radialen Seiten einer Schwenkachse des Mikroschwingspiegels angeordnet sind, und
- einer Steuervorrichtung zur Steuerung der wenigstens einen Antriebeinrichtung, wobei die Steuervorrichtung aufweist
- wenigstens eine Ansteuereinrichtung zur Ansteuerung der wenigstens zwei Kammantriebe mithilfe von Ansteuersignalen,
- wenigstens eine Elongationserfassungseinrichtung, mit welcher wenigstens ein die Elongation des Mikroschwingspiegels charakterisierendes Elongationssignal ermittelt werden kann,
- und wenigstens eine Einrichtung, welche mit der wenigstens einen Ansteuereinrichtung regelbar so verbunden ist, dass wenigstens eines der Ansteuersignale auf Basis wenigstens eines der Elongationssignale an die Schwingungsfrequenz des Mikroschwingspiegels angepasst werden kann.

### Stand der Technik

Aus der DE 10 2009 058 762 A1 ist ein zweiachsiger, kardanisch aufgehängter Mikrospiegel bekannt. Es sind elektrostatische achsenferne Kammantriebe und achsennahe Kammantriebe dargestellt, die auch als Sensorelektroden verwendet werden können. Eine Spiegelplatte ist über Torsionsfedern in einem beweglichen Rahmen aufgehängt, der wiederum durch Torsionsfedern in einem festen Chiprahmen aufgehängt ist. Der Rahmen kann durch elektrostatische Kammantriebe in Resonanz versetzt werden. Damit der Spiegel auch bei Änderung seiner Resonanzfrequenz dieser nachgeführt werden kann, weist eine Ansteuervorrichtung einen Phasenregelkreis auf, der die Phase und damit die Ansteuerfrequenz der Ansteuersignale so nachregelt, dass der Spiegel im Wesentlichen in Resonanz arbeitet. Zur Erfassung der Phasenlage ist eine Messvorrichtung vorgesehen, die die sinusförmige Elongation des Mikrospiegels misst. Bei kapazitiven Auswerteverfahren wertet man die vom Verkippwinkel abhängige, zeitlich veränderliche Kapazität zwischen statischen und beweglichen Sensor-Elektrodenfingern aus. Dazu wird eine hochfrequent modulierte Spannung an die Sensorkammstrukturen angelegt. Die Bewegung der fingerförmigen Kapazitäten erzeugt einen kapazitiven Strom, dessen Signalform eine Amplitudenmodulation des Trägersignals darstellt. In der Amplitudenmodulation ist die Information über die Spiegelbewegung enthalten und kann durch Multiplikation (Mischen) und Filterung extrahiert werden.

Aus der Veröffentlichung MOORE STEVEN IAN ET AL, "A switched actuation and sensing method for a MEMS electrostatic drive", 2016 AMERICAN CONTROL CONFERENCE (ACC), AMERICAN AUTOMATIC CONTROL COUNCIL (AACC), 6. Juli 2016 (2016-07-06), Seiten 5817 - 5822, ist ein mikroelektromechanisches System (MEMS) mit einem elektrostatischen Antrieb bekannt, welcher dazu ausgelegt ist, sowohl als Aktuator als auch als Messeinrichtung verwendet zu werden.

Aus der US 2010/043551 A1 ist ein Verfahren zur Ansteuerung eines MEMS Antriebs mit zwei Stellgliedern bekannt, bei dem die Stellglieder jeweils wechselweise und komplementär mit einer Ansteuervorrichtung und einer Vorrichtung zur Bestimmung der Auslenkung verbunden werden.

Der Erfindung liegt die Aufgabe zugrunde, ein Verfahren, eine Steuervorrichtung und eine Umlenkspiegeleinrichtung zu gestalten, bei denen der Mikroschwingspiegel besser, insbesondere energieeffizienter und/oder mit einer geringeren Störanfälligkeit, angetrieben werden kann. Insbesondere soll eine Einschwingzeit des Mikroschwingspiegels verkürzt werden.

### Offenbarung der Erfindung

Die Aufgabe wird bei dem Verfahren nach Anspruch 1 erfindungsgemäß dadurch gelöst, dass wenigstens einer der Kammantriebe mittels wenigstens einer Schalteinrichtung wechselweise mit einer Ansteuereinrichtung zum Empfangen wenigstens eines Ansteuersignals oder mit einer Elongationserfassungseinrichtung zur Erzeugung wenigstens eines Elongationssignals verbunden wird.

Erfindungsgemäß wird also wenigstens einer der Kammantriebe wechselweise zum Antrieb des Mikroschwingspiegels oder zur Erfassung der Elongation des Mikroschwingspiegels, also der momentanen Auslenkung des Mikroschwingspiegels, verwendet. Es wird also zumindest einer der wenigstens zwei Kammantriebe sowohl für den Antrieb des Mikroschwingspiegels als auch für die Bestimmung der Elongation des Mikroschwingspiegels verwendet. Der zweite der wenigstens zwei Kammantriebe wird zumindest für den Antrieb des Mikroschwingspiegels verwendet. Auf diese Weise kann mit den Kammantrieben zumindest während der Einschwingzeit die zum Antrieb benötigte Energie effizienter auf den Mikroschwingspiegel übertragen werden. Als Einschwingzeit wird die Zeit nach dem Einschalten des Antriebs des Mikroschwingspiegels bezeichnet, bis dieser für seine Verwendung ausreichend gleichmäßig insbesondere mit seiner Resonanzfrequenz schwingt.

Erfindungsgemäß wird dann nach einer Einschwingzeit des Mikroschwingspiegels wenigstens einer der Kammantriebe ausschließlich zum Antrieb des Mikroschwingspiegels und wenigstens einer der Kammantriebe ausschließlich zum Erfassen der Elongation des Mikroschwingspiegels verwendet werden. So kann nach der Einschwingzeit die zugeführte Energie verringert werden. So kann außerdem ein Risiko von Betriebsstörungen vermindert werden.

Nach der Einschwingzeit reicht es aus, lediglich die Energie zur Aufrechterhaltung der Schwingung zuzuführen. Der zur Energiezuführung nicht benötigte Kammantrieb kann ausschließlich zur Erfassung der Elongation des Mikroschwingspiegels verwendet werden. Insgesamt kann so die Steuerung nach der Einschwingzeit vereinfacht werden.

Zum Umschalten wird wenigstens eine Schalteinrichtung verwendet, mittels der wenigstens einer der Kammantriebe wechselweise mit einem entsprechenden Ansteuerzweig der Antriebseinrichtung oder einem entsprechenden Elongationserfassungszweig der Elongationserfassungseinrichtung verbunden werden kann.

Die Elongation des Mikroschwingspiegels wird durch wenigstens ein Elongationssignal charakterisiert. Das wenigstens eine Elongationssignal wird mithilfe der Elongationserfassungseinrichtung auf Basis einer Größe, die mit dem entsprechenden Kammantrieb generiert wird, insbesondere einer Kammkapazität oder einem elektrischen Strom, erzeugt. So kann ein zeitlicher Verlauf des wenigstens einen Elongationssignals den zeitlichen Verlauf der Elongation des Mikroschwingspiegels charakterisieren kann.

Es werden wenigstens zwei Ansteuersignale erzeugt. Mit den wenigstens zwei Ansteuersignalen werden die wenigstens zwei Kammantriebe wenigstens zeitweise so angesteuert, dass diese den Mikroschwingspiegel schwingend antreiben. Wenigstens zwei der wenigstens zwei Ansteuersignale können gleichen Ursprung sein. Insbesondere können wenigstens zwei der wenigstens zwei Ansteuersignale aus einem gemeinsamen Ursprungssignal erzeugt werden. Das gemeinsame Ursprungssignal kann insbesondere mittels entsprechender Umschaltmittel, beispielsweise Logikbausteinen oder dergleichen, entweder einem der Kammantriebe als eines der Ansteuersignale oder einem anderen der Kammantriebe als ein anderes Ansteuersignal zugewiesen werden. Alternativ können wenigstens zwei der wenigstens zwei Ansteuersignale unterschiedlichen Ursprungs sein. Insbesondere können die wenigstens zwei Ansteuersignale insbesondere mit wenigstens teilweise separaten Mitteln insbesondere aus unterschiedlichen Ursprungssignalen erzeugt werden. Die wenigstens zwei Ansteuersignale können auch direkt aus unterschiedlichen Ursprungssignalen gebildet werden.

Wenigstens eines der Ansteuersignale wird auf Basis wenigstens eines der Elongationssignale so geregelt, dass das wenigstens eine Ansteuersignal an die Schwingung, insbesondere die Schwingungsfrequenz, des Mikroschwingspiegels angepasst wird. Vorteilhafterweise kann der Mikroschwingspiegel mit der Antriebseinrichtung möglichst in seiner Resonanzfrequenz angetrieben werden. In der Resonanzfrequenz kann der Mikroschwingspiegel effizient angetrieben werden. Durch die Regelung des wenigstens einen Ansteuersignals können Toleranzen bezüglich der Resonanzfrequenz des Mikroschwingspiegels und/oder Änderungen der Resonanzfrequenz des Mikroschwingspiegels während des Betriebs, insbesondere während der Einschwingphase, kompensiert werden.

Ein Kammantrieb weist bekanntermaßen wenigstens eine Kammelektrodenstruktur auf, welche durch entsprechendes Anlegen einer elektrischen Spannung zur Bewegung angeregt werden kann. Dabei ist ein Teil der Elektrodenfinger der Kammelektrodenstruktur mit dem Mikroschwingspiegel und ein anderer Teil mit einem festen Rahmen des Mikroschwingspiegels verbunden. Die Fingerelektroden aufseiten des Mikroschwingspiegels greifen in die Zwischenräume zwischen den Fingerelektroden aufseiten des Rahmens ein. Durch Anlegen der entsprechenden elektrischen Spannung in Form eines Antriebsignals werden die Fingerelektroden aufseiten des Mikroschwingspiegels relativ zu den Fingerelektroden aufseiten des Rahmens ausgelenkt und damit der Mikroschwingspiegel relativ zum Rahmen schwingend angetrieben.

Vorteilhafterweise kann der angetriebene Mikroschwingspiegel eine etwa sinusförmige Schwingung durchführen. Dabei kann der Mikroschwingspiegel in einer Schwingungsrichtung mit einem der Kammantriebe und in der entgegengesetzten Schwingungsrichtung, also der Rückschwingungsrichtung, mit dem anderen der wenigstens zwei Kammantriebe aktiv angetrieben werden. Der Antrieb des Mikroschwingspiegels wird durch die jeweiligen Ansteuersignale ausgelöst. Nach Wegnahme eines Antriebspulses des entsprechenden Ansteuersignals wird der Mikroschwingspiegel aufgrund seiner Trägheit bis zum Erreichen seiner entsprechenden Amplitude ausgelenkt. Während der Schwingung des Mikroschwingspiegels kann eine elastische Rückstelleinrichtung insbesondere in Form einer Rückstellfeder, bevorzugt einer Torsionsfeder, vorgespannt werden. Die Rückstelleinrichtung kann Teil der Antriebseinrichtung sein. Nach Erreichen der Amplitude kann der Mikroschwingspiegel mittels der Rückstelleinrichtung zurückgeschwenkt werden und dabei in einem entsprechenden Zeitfenster mittels des jeweils anderen Kammantriebs angetrieben werden. Nach dem schwingen durch die Nulllage setzt der Mikroschwingspiegel seine Bewegung bis zur nächsten, der oben genannten Amplitude entgegengesetzten Amplitude fort.

Durch den Antrieb mithilfe von zwei Kammantrieben auf unterschiedlichen radialen Seiten der Schwenkachse des Mikroschwingspiegels kann die benötigte Energie zumindest während des Einschwingvorgangs effizienter eingebracht werden. Dabei kann verhindert werden, dass der Mikroschwingspiegel und/oder die Kammantriebe durch zu schnelles einseitiges Anregen des Mikroschwingspiegels beschädigt werden.

Vorteilhafterweise kann zur Bestimmung der Elongation des Mikroschwingspiegels eine Kapazitätsänderung insbesondere einer Kammelektrodenstruktur wenigstens eines Kammantriebs herangezogen werden. Aus der Kapazitätsänderung kann wenigstens ein die Elongation charakterisiertes Elongationssignal ermittelt werden.

Vorteilhafterweise kann der Mikroschwingspiegel Teil einer optischen Detektionsvorrichtung zur Erfassung von Objekten sein.

Vorteilhafterweise kann die optische Detektionsvorrichtung ein scannendes System, insbesondere ein Laserscanner, sein. Dabei kann mit Sendesignalen ein Überwachungsbereich abgetastet, also abgescannt, werden. Dazu können die entsprechenden Sendesignale, insbesondere Sendestrahlen, bezüglich ihrer Ausbreitungsrichtung über den Überwachungsbereich sozusagen geschwenkt werden. Hierbei kann wenigstens eine Umlenkspiegeleinrichtung zum Einsatz kommen, welche wenigstens einen Mikroschwingspiegel mit einer entsprechenden Steuervorrichtung und einer entsprechenden Antriebseinrichtung enthalten kann.

Die Erfindung kann bei einem Fahrzeug, insbesondere einem Kraftfahrzeug, verwendet werden. Vorteilhafterweise kann die Erfindung bei einem Landfahrzeug, insbesondere einem Personenkraftwagen, Lastkraftwagen, einem Bus, einem Motorrad oder dergleichen, einem Luftfahrzeug und/oder einem Wasserfahrzeug verwendet werden. Die Erfindung kann auch bei autonomen oder teilweise autonomen Fahrzeugen eingesetzt werden.

Die Detektionsvorrichtung kann vorteilhafterweise mit wenigstens einer elektronischen Steuervorrichtung eines Fahrzeugs, insbesondere einem Fahrerassistenzsystem, einer Fahrwerksregelung, einer Fahrer-Informationseinrichtung und/oder einem Parkassistenzsystem oder dergleichen, verbunden oder Teil einer solchen sein.

Bei einer vorteilhaften Ausgestaltung des Verfahrens kann wechselweise einer der wenigstens zwei Kammantriebe mit einer Ansteuereinrichtung verbunden werden, während ein anderer der wenigstens zwei Kammantriebe mit einer Elongationserfassungseinrichtung verbunden wird und umgekehrt. Auf diese Weise kann der Mikroschwingspiegel in jeder Schwingungsrichtung mit einem der Kammantriebe angetrieben werden. Ferner kann in jeder Schwingungsrichtung mit einem der Kammantriebe die Elongation des Mikroschwingspiegels erfasst werden. Es können so fortwährend sowohl ein Antrieb des Mikroschwingspiegels als auch eine Elongationserfassung durchgeführt werden. So kann insgesamt die Einschwingzeit des Mikroschwingspiegels verkürzt werden.

Durch den Antrieb mit den Kammantrieben auf unterschiedlichen Seiten des Mikroschwingspiegels kann insgesamt die Energiezufuhr erhöht werden. Dies trägt zur Verkürzung der Einschwingzeit bei. Durch die Ermittlung der Elongation mithilfe von jeweiligen Elongationssignalen kann der günstigste Zeitpunkt zur Wegnahme der Kammantriebe erfasst werden. So kann verhindert werden, dass die Kammantriebe die Schwingung des Mikroschwingspiegels abbremsen. Hierzu kann der entsprechende Kammantrieb mit dem entsprechenden Ansteuersignal vor Erreichen der Amplitude antriebstechnisch deaktiviert werden. Unmittelbar vor Erreichen der Amplituden der Schwingung des Mikroschwingspiegels, in denen eine Umkehrung der Schwingungsrichtung stattfindet, erfolgt kein Antrieb mit den Kammantrieben.

Das wenigstens eine Ansteuersignal kann vorteilhafterweise während etwa einem Viertel der Periodendauer der Schwingung des Mikroschwingspiegels eingeschaltet sein. In diesem Zeitfenster kann das wenigstens eine Ansteuersignal den entsprechenden Kammantrieb antreibend ansteuern. Bedingt durch die Kammelektrodenstruktur des Kammantriebs kann der Mikroschwingspiegel so nur in einem entsprechend kleinen Winkelbereich seiner Elongation angetrieben werden. Der Mikroschwingspiegel benötigt eine entsprechend längere Zeit, bis er seine Amplitude erreicht. Durch das Zuschalten des zweiten Kammantriebs beim Rückschwingen des Mikroschwingspiegels kann so insgesamt die Zeit, in der die Kammantriebe auf den Mikroschwingspiegel antreibend wirken, im Verhältnis zu der Periodendauer der Schwingung verlängert werden.

Bei einer vorteilhaften Ausgestaltung des Verfahrens kann wenigstens ein Schaltsignal erzeugt oder vorgegeben werden, mit dem die wenigstens eine Schalteinrichtung geschaltet werden kann. Auf diese Weise können die Schaltzeitpunkte der Schalteinrichtung genauer gesteuert werden.

Vorteilhafterweise kann die Schalteinrichtung wenigstens einen Schalter aufweisen. Bei dem wenigstens einen Schalter kann es sich um einen Umschalter handeln.

Mit einem Umschalter kann wenigstens ein Kammantrieb mit der Ansteuereinrichtung verbunden werden, während die Verbindung dieses wenigstens einen Kammantriebs zur entsprechenden Elongationserfassungseinrichtung getrennt wird und umgekehrt. Auf diese Weise kann mit nur einem Schalter die Umschaltung wenigstens eines Kammantriebs erfolgen.

Alternativ kann die Schalteinrichtung wenigstens zwei Schalter aufweisen. Mit wenigstens einem der wenigstens zwei Schalter kann eine Verbindung zwischen wenigstens einen Kammantrieb und der Ansteuereinrichtung geschaltet werden. Mit wenigstens einem anderen der wenigstens zwei Schalter kann eine Verbindung zwischen wenigstens einem Kammantrieb und der Elongationserfassungseinrichtung geschaltet werden. Auf diese Weise können die Schaltzeitpunkte für das Verbinden mit der Ansteuereinrichtung und das Verbinden mit der Elongationserfassungseinrichtung getrennt voneinander eingestellt werden.

Vorteilhafterweise können die Schaltsignale auf software- und/oder hardwaretechnischem Wege realisiert werden. Die Schaltsignale können vorteilhafterweise auf elektronischem Wege realisiert werden. Auf diese Weise können sie einfach und präzise eingestellt werden.

Bei einer weiteren vorteilhaften Ausgestaltung des Verfahrens können die Verbindungen zwischen dem wenigstens einen Kammantrieb einerseits und der Ansteuereinrichtung oder der Elongationserfassungseinrichtung andererseits abhängig von wenigstens einem Elongationssignal geschaltet werden. Auf diese Weise kann ein Beginn und ein Ende einer Antriebsphase des wenigstens einen Kammantriebs genauer an die Elongation des Mikroschwingspiegels angepasst werden.

Das wenigstens eine Ansteuersignal kann in einer bestimmten Schwingungsphase des Mikroschwingspiegels an den Kammantrieb zum Antrieb angelegt werden. Die Schwingungsphase kann mithilfe wenigstens eines Elongationssignals erfasst werden.

Bei einer weiteren vorteilhaften Ausgestaltung des Verfahrens kann wenigstens ein Kammantrieb wechselweise mit einem diesem zugeteilten Ansteuerzweig der Ansteuereinrichtung oder gegebenenfalls mit einem diesem Kammantrieb zugeteilten Elongationserfassungszweig der Elongationserfassungseinrichtung verbunden werden. Auf diese Weise können die Ansteuerzweige und die Elongationserfassungszweige individuell an die jeweiligen Kammantriebe angepasst werden. So können bei insbesondere bezüglich der Schwenkachse des Mikroschwingspiegels asymmetrisch angeordneten oder ausgestalteten Kammantrieben die entsprechenden Ansteuerzweige und Elongationserfassungszweige individuell angepasst werden. Mit der Erfindung können auch Kammantriebe genauer gesteuert werden, welche nicht symmetrisch bezüglich der Schwenkachse des Mikroschwingspiegels angeordnet oder ausgestaltet sind.

Vorteilhafterweise kann ein Ansteuerzweig der Ansteuereinrichtung in doppelter Ausführung vorgesehen sein. So kann jeweils einer der Ansteuerzweige für einen der Kammantriebe verwendet werden.

Alternativ oder zusätzlich kann vorteilhafterweise ein Elongationserfassungszweig in doppelter Ausführung vorgesehen sein. So kann jeweils einer der Elongationserfassungszweige für einen der Kammantriebe verwendet werden.

Wenigstens eine Schalteinrichtung, insbesondere entsprechende Schalter, können die wenigstens zwei Kammantriebe abwechselnd auf ihren jeweiligen Ansteuerzweig oder ihren jeweiligen Elongationserfassungszweig schalten. Über eine geeignete Phasenverschiebung der Ansteuersignale können die Zeitfenster zur Energiezufuhr besser eingestellt werden. Eine Sequenz zur Schaltung der Ansteuerzweige und der Elongationserfassungszweige kann über eine entsprechende Einrichtung, insbesondere eine integrierte Schaltung beispielsweise in Form eines FPGA-Bausteins, vorgegeben werden. Mit dieser Einrichtung können entsprechende Schaltsignale zur Schaltung der wenigstens einen Schalteinrichtung vorgegeben oder erzeugt werden.

Bei einer weiteren vorteilhaften Ausgestaltung des Verfahrens kann wenigstens ein Kammantrieb zwischen zwei Amplituden der Schwingung des Mikroschwingspiegels mit wenigstens einem Ansteuersignal angesteuert werden. Auf diese Weise kann dem Mikroschwingspiegel in den Schwingungsphasen mit dem wenigstens einen Kammantrieb Energie zur Beschleunigung zugeführt werden, bevor er seine größte Schwingungsgeschwindigkeit aufweist, nämlich vor Erreichen seiner Nulllage oder Ruhelage.

Vorteilhafterweise kann wenigstens ein Ansteuersignal zum Antreiben des wenigstens einen Kammantriebs ausgeschaltet werden, wenn die Kammelektrodenstrukturen des wenigstens einen Kammantriebs vollständig ineinandergreifen. Auf diese Weise kann verhindert werden, dass die Schwingung des Mikroschwingspiegels abgebremst wird. Der wenigstens eine Kammantrieb kann bezüglich einer Antriebsfunktion ausgeschaltet werden, bevor der Mikroschwingspiegel seine Nulllage oder Ruhelage erreicht. Die Kammelektrodenstrukturen des wenigstens einen Kammantriebs können so ausgestaltet sein, dass sie in der Nulllage oder Ruhelage des Mikroschwingspiegels vollständig ineinander greifen. Alternativ können die Kammelektrodenstrukturen in der Nulllage oder Ruhelage des Schwingspiegels nicht vollständig ineinandergreifen. So kann verhindert werden, dass die Kammelektrodenstrukturen sich im Totpunkt befinden, wenn der Kammantrieb gestartet wird.

Bei einer weiteren vorteilhaften Ausgestaltung des Verfahrens kann wenigstens ein Kammantrieb so lange mit wenigstens einem Ansteuersignal antreibend angesteuert werden, bis eine dem Ansteuersignal folgende Messgröße einen vorgebbaren Grenzwert erreicht. Auf diese Weise kann aus dem Ansteuersignal selbst ein geeigneter Zeitpunkt zum Ausschalten des Ansteuersignals ermittelt werden.

Vorteilhafterweise kann wenigstens ein Ansteuersignal in Form einer elektrischen Spannung an dem wenigstens einen Kammantrieb angelegt werden. Der elektrischen Spannung folgt abhängig von der Kammkapazität des wenigstens einen Kammantriebs ein elektrischer Strom. Der elektrische Strom kann gemessen werden. Der elektrische Strom kann zunehmen, bis die Kammkapazität des wenigstens einen Kammantriebs ihr Maximum erreicht. Auf diese Weise kann auf Basis der besagten Messgröße, insbesondere dem elektrischen Strom, das entsprechende Elongationssignal erzeugt werden.

Vorteilhafterweise kann der Verlauf der besagten Messgröße, insbesondere des elektrischen Stromes, insbesondere mit einem schnellen Analog-Digital-Wandler gemessen und/oder ausgewertet werden.

Bei einer weiteren vorteilhaften Ausgestaltung des Verfahrens kann während wenigstens ein Kammantrieb mit wenigstens einem Ansteuersignal antreibend angesteuert wird, ein elektrischer Kammstrom des wenigstens einen Kammantriebs als eine Größe bestimmt werden, welche eine Position von Kammelektrodenstrukturen des wenigstens einen Kammantriebs charakterisiert. Auf diese Weise kann, während der wenigstens eine Kammantrieb im Antriebsmodus betrieben wird, aus dem Kammstrom der ideale Zeitpunkt zum Anschalten und/oder Abschalten des wenigstens einen Ansteuersignals bestimmt werden. So kann auch in Betriebsphasen, in denen der wenigstens eine Kammantrieb ausschließlich im Antriebsmodus betrieben wird, das wenigstens eine Ansteuersignal gesteuert werden.

Im Antriebsmodus wird der entsprechende Kammantrieb mit wenigstens einem Ansteuersignal antreibend angesteuert. Im Unterschied dazu wird im Elongationserfassungsmodus mit dem entsprechenden Kammantrieb wenigstens ein Elongationssignal erzeugt.

Vorteilhafterweise kann der Kammstrom mithilfe von wenigstens einem ohmschen Widerstand, insbesondere einem Shunt, gegen Masse gemessen werden. Auf diese Weise kann der Kammstrom mit einfachen Mitteln bestimmt werden. Der ohmsche Widerstand kann zwischen einer der Kammelektrodenstrukturen und der Masse angeordnet sein. Gegebenenfalls kann der ohmsche Widerstand zwischen einem Signalgenerator, welcher mit der Kammelektrodenstruktur verbunden ist und mit dem das wenigstens eine Ansteuersignal ausgegeben wird, und der Masse angeordnet sein.

Vorteilhafterweise kann der Kammstrom in digitale Daten umgewandelt werden. Hierzu kann Vorteilhafterweise ein Analog-Digital-Wandler vorgesehen sein. Die digitalen Daten können mit entsprechenden elektrischen Bauteilen, insbesondere einem FPGA-Baustein, ausgewertet werden.

Vorteilhafterweise kann der Kammstrom zur Steuerung wenigstens eines Ansteuersignals eingesetzt werden. Auf diese Weise kann das wenigstens eine Ansteuersignal im idealen Zeitpunkt gestartet und beendet werden. Der ideale Zeitpunkt, um das wenigstens eine Ansteuersignal abzuschalten, damit der Mikroschwingspiegel nicht wieder abgebremst wird, ist der Moment, in dem die Kammelektrodenstrukturen des wenigstens einen Kammantriebs vollständig ineinandergreifen. Zu diesem Zeitpunkt ist die Kammkapazität am größten.

Vorteilhafterweise kann während einer Einschwingphase des Mikroschwingspiegels wenigstens ein Kammantrieb ausschließlich im Antriebsmodus betrieben werden und der Kammstrom bestimmt werden. Auf diese Weise kann der Einschwingvorgang des Mikroschwingspiegels beschleunigt werden.

Vorteilhafterweise kann aus dem Kammstrom eine Position der Kammelektrodenstrukturen des wenigstens einen Kammantriebs bestimmt werden. Aus der Position der Kammelektrodenstrukturen kann eine Elongation des Mikroschwingspiegels ermittelt werden.

Vorteilhafterweise kann der wenigstens eine Kammantrieb nach einer vorgebbaren oder vorgegebenen Anzahl von Schwingungsperioden des Mikroschwingspiegels mit der Elongationserfassungseinrichtung verbunden werden. Auf diese Weise kann mithilfe der Elongationserfassungseinrichtung die Schwingungsfrequenz des Mikroschwingspiegels an dessen Resonanzfrequenz angeglichen werden.

Ferner wird die Aufgabe erfindungsgemäß mit der Steuervorrichtung nach Anspruch 9 dadurch gelöst, dass die Steuervorrichtung wenigstens eine Schalteinrichtung aufweist, mit welcher wenigstens ein Kammantrieb wechselweise mit der wenigstens einen Ansteuereinrichtung oder mit der wenigstens einen Elongationserfassungseinrichtung verbunden werden kann. Auf diese Weise kann der Mikroschwingspiegel effizienter und schneller zur Schwingung angeregt werden. Die Einschwingzeit kann so verkürzt werden.

Für den Fall, dass die wenigstens zwei Kammantriebe bezüglich der Schwingungsachse symmetrisch angeordnet und ausgestaltet sind, können mit nur einem Ansteuerzweig der Ansteuereinrichtung und nur einem Elongationserfassungszweig der Elongationserfassungseinrichtung beide Kammantriebe entsprechend zum Antrieb oder zur Elongationserfassung geschaltet werden. Die Kammantriebe können in diesem Fall parallel geschaltet werden, wodurch die die Schaltung insgesamt vereinfacht werden kann.

Die Steuervorrichtung zum Steuern der Antriebseinrichtung kann vorteilhafterweise ein Field Programmable Gate Array (FPGA) oder einen anderen integrierten Schaltkreis aufweisen.

Bei einer vorteilhaften Ausführungsform kann wenigstens eine Schalteinrichtung wenigstens einen Schalter und die Steuervorrichtung wenigstens eine Schaltsignalerzeugungseinrichtung aufweisen, mit der wenigstens ein Schaltsignal zum Schalten des wenigstens einen Schalters erzeugt werden kann. Auf diese Weise kann eine einfache und präzise Umschaltung des wenigstens einen Kammantriebs zwischen seiner Antriebsfunktion und seiner Elongationserfassungsfunktion realisiert werden.

Vorteilhafterweise kann die Steuervorrichtung wenigstens einen Signalgenerator aufweisen zur Erzeugung wenigstens eines Ansteuersignals. Auf diese Weise kann das wenigstens eine Ansteuersignal mit einfachen Mitteln realisiert werden.

Vorteilhafterweise kann der wenigstens eine Signalgenerator in Abstimmung mit wenigstens einer Schaltsignalerzeugungseinrichtung gesteuert werden und/oder von dieser steuerbar sein. Auf diese Weise kann der wenigstens eine Signalgenerator in Abstimmung mit und/oder Abhängigkeit von Schaltsignalen, mit denen die wenigstens eine Schalteinrichtung geschaltet wird, gesteuert werden.

Vorteilhafterweise können die Elongationserfassungseinrichtung, die Steuervorrichtung, die Ansteuereinrichtung und/oder die Schaltsignalerzeugungseinrichtung auf Software- und/oder hardwaretechnischem Wege realisiert werden. Die besagten Einrichtungen und Vorrichtungen können mithilfe von elektrischen/elektronischen und/oder mechanischen Bauteilen realisiert werden.

Außerdem wird die Erfindung erfindungsgemäß bei der Umlenkspiegeleinrichtung nach Anspruch 11 dadurch gelöst, die Steuervorrichtung wenigstens eine Schalteinrichtung aufweist, mit welcher wenigstens ein Kammantrieb wechselweise mit der wenigstens eine Ansteuereinrichtung oder mit der wenigstens einen Elongationserfassungseinrichtung verbunden werden kann. Auf diese Weise kann der Mikroschwingspiegel effizienter und schneller zur Schwingung angeregt werden. Die Einschwingphase kann so verkürzt werden.

### Kurze Beschreibung der Zeichnungen

Weitere Vorteile, Merkmale und Einzelheiten der Erfindung ergeben sich aus der nachfolgenden Beschreibung, in der Ausführungsbeispiele der Erfindung anhand der Zeichnung näher erläutert werden. Der Schutzumfang wird durch die Ansprüche definiert.

Es zeigen schematisch
- Figur 1: ein Fahrzeug in der Vorderansicht, mit einem Laserscanner zur Überwachung eines Überwachungsbereichs in Fahrtrichtung vor den Fahrzeug;
- Figur 2: einen Schaltungsaufbau einer Umlenkspiegeleinrichtung des Laserscanners aus der Figur 1, mit einem Mikroschwingspiegel und einer Steuerungsvorrichtung für eine Antriebseinrichtung des Mikroschwingspiegels;
- Figur 3: zeitliche Verläufe eines Ansteuersignals zur Ansteuerung der Antriebseinrichtung, einer Elongation des Mikroschwingspiegels und eines Elongationssignals, welches den zeitlichen Verlauf der Elongation des Mikroschwingspiegels charakterisiert;
- Figur 4: einen Schaltungsaufbau eines Teils der Steuerungsvorrichtung mit einer Schaltungseinrichtung für die Antriebseinrichtung des Mikroschwingspiegels aus der Figur 2;
- Figur 5: zeitliche Verläufe von vier Schaltsignalen, mit welchen die Schalteinrichtung aus der Figur 4 geschaltet wird.

In den Figuren sind gleiche Bauteile mit gleichen Bezugszeichen versehen.

### Ausführungsform(en) der Erfindung

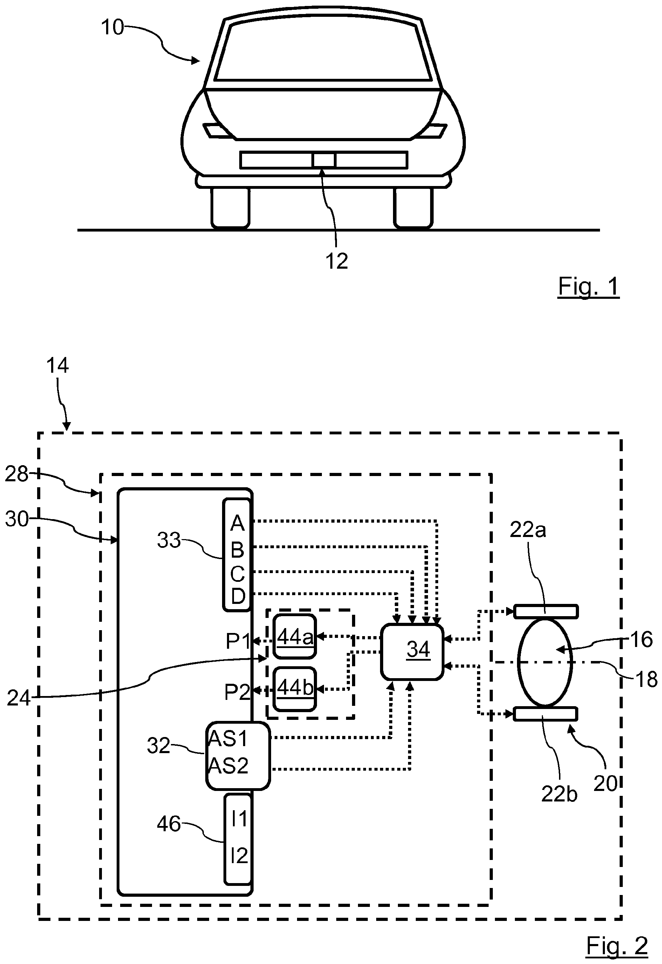

In der Figur 1 ist ein Fahrzeug beispielhaft in Form eines Personenkraftwagens in der Vorderansicht gezeigt. Das Fahrzeug 10 umfasst eine abtastende optische Detektionsvorrichtung beispielhaft in Form eines Laserscanners 12. Der Laserscanner 12 ist beispielhaft in der vorderen Stoßstange des Fahrzeugs 10 angeordnet. Der Laserscanner 12 kann auch an einer anderen Stelle des Fahrzeugs 10 angeordnet sein.

Mit dem Laserscanner 12 kann ein Überwachungsbereich beispielhaft in Fahrtrichtung des Fahrzeugs 10 vor dem Fahrzeug 10 auf Objekte hin überwacht werden. Hierzu kann mit dem Laserscanner 12 der Überwachungsbereich mit entsprechenden Sendesignalen abgetastet werden. Bei Vorhandensein eines Objekts werden die Sendesignale reflektiert und zu dem Laserscanner 12 zurückgesendet. Mit einem entsprechenden Empfänger des Laserscanners 12 werden die reflektierten Signale empfangen.

Der Laserscanner 12 arbeitet nach einem sogenannten Laufzeitverfahren, bei dem eine Laufzeit zwischen dem Aussenden eines Sendesignals und dem Empfang eines reflektierten Sendesignals erfasst und daraus eine Entfernung, eine Geschwindigkeit und/oder eine Richtung des Objekts relativ zum Fahrzeug 10 bestimmt werden kann.

Der Laserscanner 12 weist einen Sender zum Aussenden von Sendesignalen, einen Empfänger zum Empfangen der reflektierten Sendesignale, eine Umlenkspiegeleinrichtung 14 zum Umlenken der Sendesignale und eine Steuer- und Auswerteeinrichtung zur Steuerung des Senders, des Empfängers und der Umlenkspiegeleinrichtung 14 und zum Auswerten von empfangenen Signalen auf. Mit der Umlenkspiegeleinrichtung 14 werden die Strahlrichtungen der Sendesignale in dem Überwachungsbereich geschwenkt, sodass dieser mit den Sendesignalen abgetastet werden kann.

In der Figur 2 ist ein Schaltungsaufbau der Umlenkspiegeleinrichtung 14 gezeigt. Die Umlenkspiegeleinrichtung 14 umfasst einen Mikroschwingspiegel 16. Der Mikroschwingspiegel 16 ist als sogenanntes Mikrosystem-Bauteil ausgelegt, welches in englischsprachigen als Micro-Electro-Mechanical-Systems (MEMS) bezeichnet wird. Der Mikroschwingspiegel 16 kann um eine Schwenkachse 18 zwischen Amplituden, also Maximalauslenkungen, hin- und hergeschwenkt werden.

Der Mikroschwingspiegel 16 kann mit einer Antriebseinrichtung 20 verbunden. Die Antriebseinrichtung 20 weist zwei sogenannte Kammantriebe 22a und 22b auf, mit denen der Mikroschwingspiegel 16 antreibbar ist. Die Kammantriebe 22a und 22b können außerdem zu Sensorzwecken zur Erfassung einer Elongation 26, also einer momentanen Auslenkung, des Mikroschwingspiegels 16 verwendet werden.

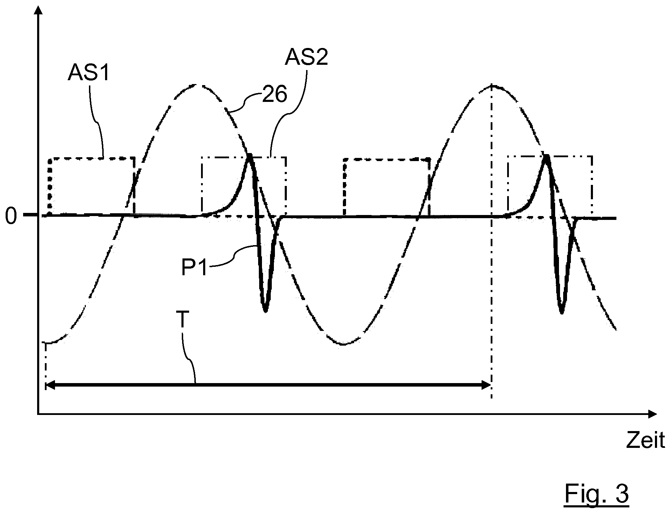

Die Kammantriebe 22a und 22b werden mit elektrischer Spannung betrieben. Die Kammantriebe 22a und 22b sind beispielhaft mit zusammenwirkenden Kammelektrodenstrukturen ausgestattet, welche durch Anlegen eines jeweiligen Ansteuersignals AS1 oder AS2 angesteuert werden können. Der zeitliche Verlauf des ersten Ansteuersignals AS1 zum Ansteuern des ersten Kammantriebs 22a ist beispielhaft in der Figur 3 in gepunktete Linie gezeigt. Nur zur Orientierung ist der zeitliche Verlauf des zweiten Ansteuersignals AS2 zum Ansteuern des zweiten Kammantriebs 22a strichgepunktet angedeutet.

Ferner verfügt die Umlenkspiegeleinrichtung 14 über eine Elongationserfassungseinrichtung 24, mit welcher die Elongation 26 im zeitlichen Verlauf erfasst werden kann. Die Elongationserfassungseinrichtung 24 nutzt hierfür die Kammelektrodenstrukturen der Kammantriebe 22a und 22b. Dabei wird ein Lade- und Entladestrom in einer sich ändernden Kammkapazität des jeweiligen Kammantriebs 22a oder 22b erfasst. Die Kammkapazität und damit der Lade- und Entladestrom ändert sich aufgrund der Schwingung des Mikroschwingspiegels 16. Die Kapazitätsänderung wird in eine proportionale elektrische Spannung gewandelt, wobei die Frequenz der Spannung die Schwingungsfrequenz des Mikroschwingspiegels 16 und die Amplitudenänderung der Spannung ein Maß für die Elongation 26 des Mikroschwingspiegels 16 ist. Die in eine Amplitudenänderung umgewandelte Kammkapazität wird als entsprechendes Elongationssignal P1 beziehungsweise P2 ausgegeben. Die Elongationssignale P1 und P2 charakterisieren die Elongation 26 des Mikroschwingspiegel 16 im zeitlichen Verlauf. Der zeitliche Verlauf des ersten Elongationssignals P1, welches mit Hilfe des ersten Kammantriebs 22a ermittelt wird, ist beispielhaft in der Figur 3 gezeigt.

In Figur 3 ist beispielhaft der zeitliche Verlauf der Elongation 26 des Mikroschwingspiegels 16 als Sinuskurve, der zeitliche Verlauf des ersten Ansteuersignals AS1 für den ersten Kammantrieb 22a in Form eines periodischen Rechtecksignals und der zeitliche Verlauf des ersten Elongationssignals P1, welches mithilfe des ersten Kammantriebs 22a erzeugt wird, in Form eines periodischen bipolaren Pulses dargestellt. Die Darstellung in Figur 3 dient lediglich dem Vergleich der zeitlichen Verläufe des ersten Ansteuersignals AS1, des ersten Elongationssignals P1 und der Elongation 26. Sonstige Maßstäbe und Einheiten stimmen nicht überein.

Die Ansteuersignale AS1 und AS2 werden auf Basis der Elongationssignale P1 und P2 an die Schwingungsfrequenz des Mikroschwingspiegels 16 angepasst. Auf diese Weise wird erreicht, dass der Mikroschwingspiegel 16 möglichst in seiner Resonanzfrequenz angetrieben wird.

Zur Ansteuerung der Antriebseinrichtung 20, respektive der Kammantriebe 22a und 22b, ist eine Steuervorrichtung 28 vorgesehen. Die Steuervorrichtung 28 weist beispielhaft einen sogenannten FPGA-Baustein 30 auf.

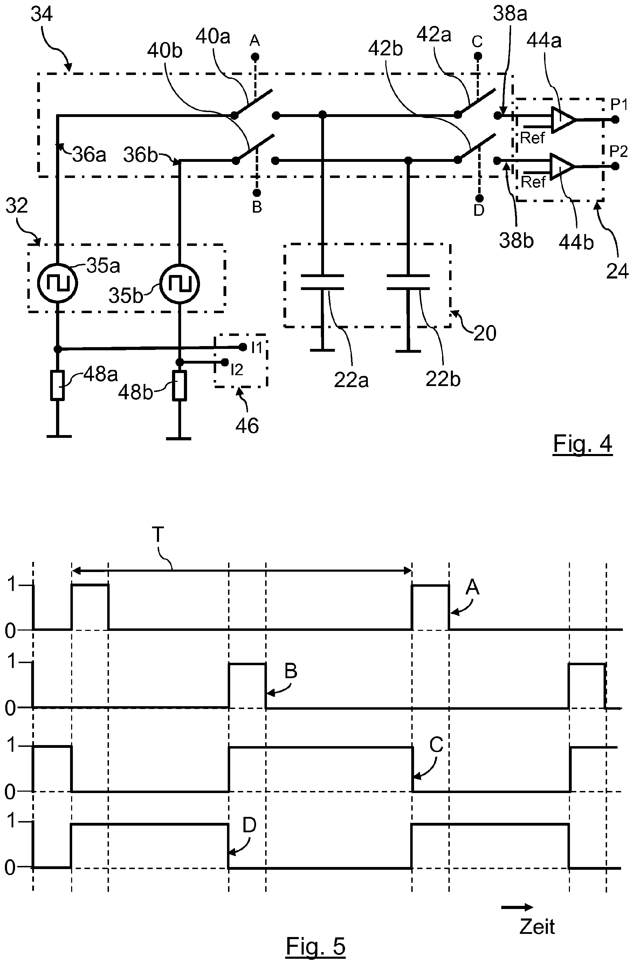

Der FPGA-Baustein 30 umfasst einen Teil eine Ansteuereinrichtung 32. Die Ansteuereinrichtung 32 verfügt außerdem über zwei Signalgeneratoren 35a und 35b, welche in der Figur 4 gezeigt sind, zur Erzeugung der Ansteuersignale AS1 und AS2.

Ferner umfasst der FPGA-Baustein 30 eine Schaltsignalerzeugungseinrichtung 33, mit der weiter unten näher erläuterte Schaltsignale A, B, C und D erzeugt werden können.

Außerdem können mit dem FPGA-Baustein 30 auf Basis der Elongationssignale P1 und P2 die Ansteuersignale AS1 und AS2, und die Schaltsignale A, B, C und D geregelt werden.

Des Weiteren umfasst der FPGA-Baustein 30 optional eine Kamm-Positionserfassungseinrichtung 46. Mit der Kamm-Positionserfassungseinrichtung 46 kann der Kammstrom 11 des ersten Kammantriebs 22a ermittelt werden, solange dieser sich im Antriebsmodus befindet. Außerdem kann mit der Kamm-Positionserfassungseinrichtung 46 der Kammstrom I2 zweiten Kammantriebs 22b ermittelt werden, solange dieser sich im Antriebsmodus befindet. Aus den Kammströmen I1 und I2 können die Positionen der Kammelektrodenstrukturen der entsprechenden Kammantriebe 22a beziehungsweise 22b ermittelt werden.

Die Ansteuereinrichtung 32 und die Schaltsignalerzeugungseinrichtung 33 sind signaltechnisch mit der Elongationserfassungseinrichtung 24 und einer Schalteinrichtung 34 verbunden. Mit der Schalteinrichtung 34 können die Kammantriebe 22a und 22b jeweils wechselweise mit der Ansteuereinrichtung 32 oder der Elongationserfassungseinrichtung 24 verbunden werden.

Die Schalteinrichtung 34 ist im Detail in der Figur 4 gezeigt.

Die Schalteinrichtung 34 umfasst einen ersten Ansteuerzweig 36a für die Ansteuerung des ersten Kammantriebs 22a und einen zweiten Ansteuerzweig 36b für die Ansteuerung des zweiten Kammantriebs 22b.

Ferner umfasst die Schalteinrichtung 34 einen ersten Elongationserfassungszweig 38a, mit dem der erste Kammantrieb 22a zur Erzeugung des ersten Elongationssignals P1 verbunden werden kann, und einen zweiten Elongationserfassungszweig 38b, mit dem der zweite Kammantrieb 22b zur Erzeugung des zweiten Elongationssignals P2 verbunden werden kann.

Ein Ausgang des ersten Ansteuerzweigs 36a ist über einen ersten Ansteuerschalter 40a mit dem ersten Kammantrieb 22a verbindbar. Ein Ausgang des zweiten Ansteuerzweigs 36b ist über einen zweiten Ansteuerschalter 40b mit dem zweiten Kammantrieb 22b verbindbar. Die Kammantriebe 22a und 22b liegen darüber hinaus auf Masse.

Ein Eingang des ersten Elongationserfassungszweigs 38a ist über einen ersten Elongationsschalter 42a mit dem ersten Kammabtrieb 22a verbindbar. Ein Eingang des zweiten Elongationserfassungszweigs 38b ist über einen zweiten Elongationsschalter 42b mit dem zweiten Kammantrieb 22b verbindbar.

Der erste Ansteuerzweig 36a ist über den Ausgang der Ansteuereinrichtung 32 für das erste Ansteuersignal AS1 mit dem ersten Signalgenerator 35a verbunden. Der erste Signalgenerator 35a ist über einen ersten ohmschen Widerstand 48a beispielsweise in Form eines Shunts auf Masse gelegt. Zwischen dem ersten Signalgenerator 35a und dem ersten Widerstand 48a ist ein Abgriff für den ersten Kammstrom 11 vorgesehen, welcher mit dem entsprechenden Eingang der Kamm-Positionserfassungseinrichtung 46 verbunden ist.

Der zweite Ansteuerzweig 36b ist über den Ausgang der Ansteuereinrichtung 32 für das zweite Ansteuersignal AS2 mit dem zweiten Signalgenerator 35b verbunden. Der zweite Signalgenerator 35b ist über einen zweiten ohmschen Widerstand 48b beispielsweise in Form eines Shunts auf Masse gelegt. Zwischen dem zweiten Signalgenerator 35b und dem zweiten Widerstand 48b ist ein Abgriff für den zweiten Kammstrom I2 vorgesehen, welcher mit dem entsprechenden Eingang der Kamm-Positionserfassungseinrichtung 46 verbunden ist.

Ein Ausgang des ersten Elongationserfassungszweigs 38a ist mit einem Eingang eines ersten Transimpedanzverstärkers 44a der Elongationserfassungseinrichtung 24 verbunden. Ein Ausgang des zweiten Elongationserfassungszweigs 38b ist mit einem Eingang eines zweiten Transimpedanzverstärkers 44b der Elongationserfassungseinrichtung 24 verbunden. An den jeweils andere Eingängen der Transimpedanzverstärker 44a und 44b liegt eine jeweilige Referenzspannung Ref an. Die Referenzspannungen Ref der Transimpedanzverstärker44a und 44b können unterschiedlich oder gleich vorgegeben oder einstellbar sein.

Am Ausgang des ersten Transimpedanzverstärkers 44a liegt das erste Elongationssignal P1 an, welches dem FPGA-Baustein 30 übermittelt wird. Am Ausgang des zweiten Transimpedanzverstärkers 44b liegt das zweite Elongationssignal P2 an, welches ebenfalls dem FPGA-Baustein 30 übermittelt wird.

Die Ansteuerschalter 40a und 40b und die Elongationsschalter 42a und 42b sind mit den jeweiligen Ausgängen der Schaltsignalerzeugungseinrichtung 33, an denen die entsprechenden Schaltsignale A, B, C und D anliegen, verbunden. Dabei wird der erste Ansteuerschalter 40a mit dem ersten Schaltsignal A, der zweite Ansteuerschalter 40b mit dem zweiten Schaltsignal B, der erste Elongationsschalter 42a mit dem dritten Schaltsignal C und der zweite Elongationsschalter 42b mit dem vierten Schaltsignal D geschaltet. Ein zeitlicher Ausschnitt der Schaltsignale A, B, C und D während etwa der 1,5-fachen Periodendauer T der Schwingung des Mikroschwingspiegels 16 ist in der Figur 5 gezeigt.

Mithilfe der Schaltsignale A, B, C und D werden die Kammantriebe 22a und 22b mittels der Schalteinrichtung 34 jeweils wechselweise mit der Ansteuereinrichtung 32 oder mit der Elongationserfassungseinrichtung 24 verbunden.

Bei den Schaltsignalen A, B, C und D handelt es sich um periodische Rechtecksignale, welche jeweils mit der Periodendauer T der Schwingung des Mikroschwingspiegels 16 zwischen 0 und 1 wechseln. Steht ein Schaltsignal auf 1 wird der entsprechende Schalter geschlossen. Steht das Schaltsignal auf 0 wird der entsprechende Schalter geöffnet.

Das erste Schaltsignal A und das vierte Schaltsignal D wechseln gleichzeitig auf 1, sodass der erste Ansteuerschalter 40a und der zweite Elongationsschalter 42b gleichzeitig geschlossen werden.

Das erste Schaltsignal A und das vierte Schaltsignal D schalten entsprechend der Schwingung des Mikroschwingspiegels 16 auf 1, sobald der Mikroschwingspiegel 16 eine in der Figur 3 unteren Amplitude seiner Schwingung verlässt, sich also zwischen der unteren Amplitude und einer nachfolgenden oberen Amplitude befindet.

Das erste Schaltsignal A schaltet auf 0, sobald der Mikroschwingspiegel 16 seinen Nulllage durchläuft. Während das erste Schaltsignal A auf 1 steht, wird mit dem ersten Ansteuerzweig 36a das erste Ansteuersignal AS1 des ersten Signalgenerator 35a an den ersten Kammantrieb 22a übermittelt, sodass dieser den Mikroschwingspiegel 16 antreibt.

Das vierte Schaltsignal D wechselt auf 0, sobald der Mikroschwingspiegel 16 die obere Amplitude seiner Schwingung verlässt. Während das vierte Schaltsignal D auf 1 steht, ist der zweite Kammantrieb 22b über den zweiten Elongationserfassungszweig 38b mit dem zweiten Transimpedanzverstärker 44b der Elongationserfassungseinrichtung 24 verbunden, mit dem das zweite Elongationssignal P2 erzeugt und an den FPGA-Baustein 30 übermittelt wird.

Das zweite Schaltsignal B und das dritte Schaltsignal C schalten entsprechend der Schwingungsperiode des Mikroschwingspiegels 16 auf 1, sobald der Mikroschwingspiegel 16 eine in der Figur 3 obere Amplitude seiner Schwingung verlässt, sich also zwischen der oberen Amplitude und einer nachfolgenden unteren Amplitude befindet. In dem Ausführungsbeispiel schalten das zweite Schaltsignal B und das dritte Schaltsignal C auf 1, sobald das vierte Schaltsignal D auf 0 schaltet.

Das zweite Schaltsignal B schaltet auf 0, sobald der Mikroschwingspiegel 16 die Nulllage seiner Schwingung durchläuft. Während das zweite Schaltsignal B auf 1 steht, wird mit dem zweiten Ansteuerzweig 36b das zweite Ansteuersignal AS2 des zweiten Signalgenerators 35b an den zweiten Kammantrieb 22b übermittelt, sodass dieser den Mikroschwingspiegel 16 antreibt.

Das dritte Schaltsignal C wechselt auf 0, sobald der Mikroschwingspiegel 16 die untere Amplitude seiner Schwingung verlässt. Während das dritte Schaltsignal C auf 1 steht, ist der erste Kammantrieb 22a über den ersten Elongationserfassungszweig 38a mit dem ersten Transimpedanzverstärker 44a der Elongationserfassungseinrichtung 24 verbunden, mit dem das erste Elongationssignal P1 erzeugt und an den FPGA-Baustein 30 übermittelt wird.

Durch die periodische Umschaltung der Kammantriebe 22a und 22b zwischen Antriebsmodus und Elongationserfassungsmodus kann fortwährend die Elongation des Mikroschwingspiegels 16 mithilfe der Elongationssignale P1 und P2 ermittelt werden. Ferner kann der Mikroschwingspiegel 16 in jeder Anstiegsflanke und jeder Abstiegsflanke seiner Schwingung mit einem der Kammantriebe 22a oder 22b angetrieben werden. So kann die Einschwingzeit des Mikroschwingspiegels 16 verringert werden, ohne dass die Energiezufuhr für jeden einzelnen Kammantrieb 22a und 22b vergrößert werden muss.

Ferner können mithilfe der Elongationssignale P1 und P2 die Ansteuersignale AS1 und AS2 und die Schaltsignale A, B, C und D so geregelt werden, dass der Mikroschwingspiegel 16 möglichst in seiner Resonanzfrequenz schwingt.

Optional können nach der Einschwingzeit des Mikroschwingspiegels 16 die Schaltsignale A, B, C und D so geändert werden, dass einer der Kammantriebe, beispielsweise der erste Kammantrieb 22a, stets im Antriebsmodus betrieben wird, und der andere Kammantrieb, beispielsweise der zweite Kammantrieb 22b, stets in dem Elongationserfassungsmodus betrieben wird. Auf diese Weise kann der Mikroschwingspiegel 16 energiesparender angetrieben werden, indem lediglich die Energie zugeführt wird, welche zur Aufrechterhaltung der Schwingung des Mikroschwingspiegels 16 erforderlich ist.

Ferner kann optional mittels der Kamm-Positionserfassungseinrichtung 46 die Position der Kammelektrodenstrukturen der jeweiligen Kammantriebe 22a und 22b durch Messung der Kammströme I1 beziehungsweise I2 ermittelt werden. Dabei kann der erste Kammstrom 11 über den ersten Widerstand 48a gegen Masse gemessen werden, wenn sich der erste Kammantrieb 22a im Antriebsmodus befindet, also der erste Ansteuerschalter 40a geschlossen ist. Der zweite Kammstrom I2 kann über den zweiten Widerstand 48b gegen Masse gemessen werden, wenn sich der zweite Kammantrieb 22b im Antriebsmodus befindet, also der zweite Ansteuerschalter 40a geschlossen ist.

Befindet sich der erste Kammantrieb 22a im Antriebsmodus, so steigt der erste Kammstrom I1 solange an, bis die Kammelektrodenstrukturen des ersten Kammantriebs 22a vollständig ineinandergreifen. In dieser Position hat die Kammkapazität des ersten Kammantriebs 22a ihr Maximum. Dies ist der ideale Zeitpunkt, um das erste Ansteuersignal AS1 abzuschalten, damit ein Abbremsen des ersten Kammantriebs 22a und damit ein abbremsen der Schwingung des Mikroschwingspiegels 16 verhindert wird.

Entsprechend steigt im Antriebsmodus des zweiten Kammantriebs 22b der zweite Kammstrom I2 bis zum vollständigen ineinandergreifen der Kammelektrodenstrukturen des zweiten Kammantriebs 22a an. Entsprechend ist der ideale Zeitpunkt zum Abschalten des zweiten Ansteuersignals AS2 das Erreichen des Maximums der Kammkapazität des zweiten Kammantriebs 22b.

Die Signale aus den Kammströmen I1 und I2 können beispielsweise mit einem Analog-Digital-Wandler (ADC) ausgewertet und der Schaltsignalerzeugungseinrichtung 33 zum Einstellen der Schaltsignale A, B, C und D bereitgestellt werden. Der Analog-Digital-Wandler kann Teil des FPGA-Bausteins 30 sein.

Die Steuerung der Ansteuersignale AS1 und AS2 mit der Kamm-Positionserfassungseinrichtung 46 über wenigstens einen der Kammströme I1 und I2 kann auch in Betriebssituationen erfolgen, in denen der entsprechende Kammantrieb 22a und/oder 22b ausschließlich im Antriebsmodus, also nicht wechselweise im Antriebsmodus oder im Positionserfassungsmodus, geschaltet ist. Dabei können auch beide Kammantriebe 22a und 22b im Antriebsmodus geschaltet sind. So kann bei einem Start der Antriebseinrichtung 20 ein schnelleres Einschwingen des Mikroschwingspiegels 16 erreicht werden.

Um die Resonanzfrequenz des Mikroschwingspiegels 16 zu bestimmen, kann wenigstens einer der Kammantriebe 22a und 22b in regelmäßigen oder unregelmäßigen Abständen in den Positionserfassungsmodus geschaltet und mit der Elongationserfassungseinrichtung 24 werden. Beispielsweise kann wenigstens einer der Kammantriebe 22a und 22b nach einer vorgebbaren oder vorgegebenen Anzahl von Schwingungsperioden des Mikroschwingspiegels 16 mit der Elongationserfassungseinrichtung 24 verbunden werden. Mithilfe der Elongationserfassungseinrichtung 24 kann die Schwingungsfrequenz des Mikroschwingspiegels an dessen Resonanzfrequenz angeglichen werden.

Beispielsweise können bei einer symmetrischen Anordnung der Kammantriebe 22a und 22b bezüglich der Schwenkachse 18 die Kammantriebe 22a und 22b mittels der entsprechenden Ansteuersignale AS1 und AS2 zum zeitgleichen Antrieb angesteuert werden. Bei einer unsymmetrischen Anordnung der Kammantriebe 22a und 22b bezüglich der Schwenkachse 18 können die Kammantriebe 22a und 22b mittels der Ansteuersignale AS1 und AS2 zum zeitlich versetzten Antrieb angesteuert werden, um die unsymmetrische Anordnung auszugleichen.

## Patentansprüche

1. Verfahren zur Steuerung einer Antriebseinrichtung (20) eines Mikroschwingspiegels (16), wobei die Antriebseinrichtung (20) wenigstens zwei Kammantriebe (22a, 22b) aufweist, welche auf unterschiedlichen radialen Seiten einer Schwenkachse (18) des Mikroschwingspiegels (16) angeordnet sind, wobei bei dem Verfahren
- wenigstens zwei Ansteuersignale (AS1, AS2) erzeugt und damit die wenigstens zwei Kammantriebe (22a, 22b) wenigstens zeitweise so angesteuert werden, dass diese den Mikroschwingspiegel (16) schwingend antreiben,
- wenigstens ein die Elongation (26) des Mikroschwingspiegels (16) charakterisierendes Elongationssignal (P1, P2) mithilfe wenigstens eines Kammantriebs (22a, 22b) erzeugt wird,
- wenigstens eines der Ansteuersignale (AS1, AS2) auf Basis wenigstens eines der Elongationssignale (P1, P2) an die Schwingung des Mikroschwingspiegels (16) angepasst wird,
- während einer Einschwingzeit des Mikroschwingspiegels (16) wenigstens einer der Kammantriebe (22a, 22b) mittels wenigstens einer Schalteinrichtung (34) wechselweise mit einer Ansteuereinrichtung (32) zum Empfangen wenigstens eines Ansteuersignals (AS1, AS2) oder mit einer Elongationserfassungseinrichtung (24) zur Erzeugung wenigstens eines Elongationssignals (P1, P2) verbunden wird,
**dadurch gekennzeichnet, dass**
nach einer Einschwingzeit des Mikroschwingspiegels (16) wenigstens einer der Kammantriebe (22a, 22b) ausschließlich zum Antrieb des Mikroschwingspiegels (16) und
wenigstens einer der Kammantriebe (22a, 22b) ausschließlich zum Erfassen der Elongation (26) des Mikroschwingspiegels (16) verwendet wird.

2. Verfahren nach Anspruch 1, **dadurch gekennzeichnet, dass** während einer Einschwingzeit des Mikroschwingspiegels (16) wechselweise einer der wenigstens zwei Kammantriebe (22a, 22b) mit einer Ansteuereinrichtung (32) verbunden wird, während ein anderer der wenigstens zwei Kammantriebe (22a, 22b) mit einer Elongationserfassungseinrichtung (24) verbunden wird und umgekehrt.

3. Verfahren nach Anspruch 1 oder 2, **dadurch gekennzeichnet, dass** wenigstens ein Schaltsignal (A, B, C, D) erzeugt oder vorgegeben wird, mit dem die wenigstens eine Schalteinrichtung (34) geschaltet wird.

4. Verfahren nach einem der vorigen Ansprüche, **dadurch gekennzeichnet, dass** die Verbindungen zwischen dem wenigstens einen Kammantrieb (22a, 22b) einerseits und der Ansteuereinrichtung (32) oder der Elongationserfassungseinrichtung (24) andererseits abhängig von wenigstens einem Elongationssignal (P1, P2) geschaltet werden.

5. Verfahren nach einem der vorigen Ansprüche, **dadurch gekennzeichnet, dass** während einer Einschwingzeit des Mikroschwingspiegels (16) wenigstens ein Kammantrieb (22a, 22b) wechselweise mit einem diesem zugeteilten Ansteuerzweig (36a, 36b) der Ansteuereinrichtung (32) oder gegebenenfalls mit einem diesem Kammantrieb (22a, 22b) zugeteilten Elongationserfassungszweig (38a, 38b) der Elongationserfassungseinrichtung (24) verbunden wird.

6. Verfahren nach einem der vorigen Ansprüche, **dadurch gekennzeichnet, dass** wenigstens ein Kammantrieb (22a, 22b) zwischen zwei Amplituden der Schwingung des Mikroschwingspiegels (16) mit wenigstens einem Ansteuersignal (AS1, AS2) angesteuert wird.

7. Verfahren nach einem der vorigen Ansprüche, **dadurch gekennzeichnet, dass** wenigstens ein Kammantrieb (22a, 22b) so lange mit wenigstens einem Ansteuersignal (AS1, AS2) antreibend angesteuert wird, bis eine dem Ansteuersignal (AS1, AS2) folgende Messgröße einen vorgebbaren Grenzwert erreicht.

8. Verfahren nach einem der vorigen Ansprüche, **dadurch gekennzeichnet, dass** während wenigstens ein Kammantrieb (22a, 22b) mit wenigstens einem Ansteuersignal (AS1, AS2) antreibend angesteuert wird, ein elektrischer Kammstrom (I1, I2) des wenigstens einen Kammantriebs (22a, 22b) als eine Größe bestimmt wird, welche eine Position von Kammelektrodenstrukturen des wenigstens einen Kammantriebs (22a, 22b) charakterisiert.

9. Steuervorrichtung (28) zur Steuerung wenigstens einer Antriebseinrichtung (20) eines Mikroschwingspiegels (16), wobei die wenigstens eine Antriebseinrichtung (20) wenigstens zwei Kammantriebe (22a, 22b) aufweist, welche auf unterschiedlichen radialen Seiten einer Schwenkachse (18) des Mikroschwingspiegels (16) angeordnet sind,
- mit wenigstens einer Ansteuereinrichtung (32) die zur Ansteuerung der wenigstens zwei Kammantriebe (22a, 22b) mithilfe von Ansteuersignalen (AS1, AS2) eingerichtet ist,
- mit wenigstens einer Elongationserfassungseinrichtung (24), welche dazu eingerichtet ist, wenigstens ein die Elongation (26) des Mikroschwingspiegels (16) charakterisierendes Elongationssignal (P1, P2) zu ermitteln,
- und mit wenigstens einer Einrichtung (34), welche mit der wenigstens einen Ansteuereinrichtung (32) regelbar so verbunden ist, dass wenigstens eines der Ansteuersignale (AS1, AS2) auf Basis wenigstens eines der Elongationssignale (P1, P2) an die Schwingungsfrequenz des Mikroschwingspiegels (16) angepasst werden kann, und die Steuervorrichtung (28) wenigstens eine Schalteinrichtung (34) aufweist, welche dazu eingerichtet ist, während einer Einschwingzeit des Mikroschwingspiegels (16) wenigstens einen Kammantrieb (22a, 22b) wechselweise mit der wenigstens einen Ansteuereinrichtung (32) oder mit der wenigstens einen Elongationserfassungseinrichtung (24) zu verbinden,
**dadurch gekennzeichnet, dass**
die Steuervorrichtung (28) ferner dazu eingerichtet ist, nach einer Einschwingzeit des Mikroschwingspiegels (16) wenigstens einen der Kammantriebe (22a, 22b) ausschließlich zum Antrieb des Mikroschwingspiegels (16) und wenigstens einen der Kammantriebe (22a, 22b) ausschließlich zum Erfassen der Elongation (26) des Mikroschwingspiegels (16) zu verwenden.

10. Steuervorrichtung nach Anspruch 9, **dadurch gekennzeichnet, dass** wenigstens eine Schalteinrichtung (34) wenigstens einen Schalter (40a, 40b, 42a, 42b) und die Steuervorrichtung (28) wenigstens eine Schaltsignalerzeugungseinrichtung (33) aufweist, mit der wenigstens ein Schaltsignal (A, B, C, D) zum Schalten des wenigstens einen Schalters erzeugt werden kann.

11. Umlenkspiegeleinrichtung (14) einer optischen Detektionsvorrichtung (12) mit
- wenigstens einem Mikroschwingspiegel (16),
- wenigstens einer Antriebseinrichtung (20) für den wenigstens einen Mikroschwingspiegel (16), wobei die Antriebseinrichtung (20) wenigstens zwei Kammantriebe (22a, 22b) aufweist, welche auf unterschiedlichen radialen Seiten einer Schwenkachse (18) des Mikroschwingspiegels (16) angeordnet sind, und
- einer Steuervorrichtung (28) nach Anspruch 9 oder 10.

## Claims

1. Method for controlling a drive apparatus (20) of a micro-oscillation mirror (16), wherein the drive apparatus (20) has at least two comb drives (22a, 22b) which are arranged on different radial sides of a pivoting axis (18) of the micro-oscillation mirror (16), wherein in the method:
- at least two actuation signals (AS1, AS2) are generated, and the at least two comb drives (22a, 22b) are therefore actuated at least temporarily in such a way that they drive the micro-oscillation mirror (16) in an oscillating fashion,
- at least one elongation signal (P1, P2), which characterizes the elongation (26) of the micro-oscillation mirror (16) is generated using at least one comb drive (22a, 22b),
- at least one of the actuation signals (AS1, AS2) is adapted to the oscillation of the micro-oscillation mirror (16) on the basis of at least one of the elongation signals (P1, P2),
- during a transient recovery time of the micro-oscillation mirror (16) at least one of the comb drives (22a, 22b) is connected, by means of at least one switching apparatus (34), alternately to an actuation apparatus (32) for receiving at least one actuation signal (AS1, AS2) or to an elongation-detection apparatus (24) for generating at least one elongation signal (P1, P2),
**characterized in that**
after a transient recovery time of the micro-oscillation mirror (16) at least one of the comb drives (22a, 22b) is used exclusively to drive the micro-oscillation mirror (16), and at least one of the comb drives (22a, 22b) is used exclusively to detect the elongation (26) of the micro-oscillation mirror (16).

2. Method according to Claim 1, **characterized in that** during a transient recovery time of the micro-oscillation mirror (16) one of the at least two comb drives (22a, 22b) is alternately connected to an actuation apparatus (32), while another one of the at least two comb drives (22a, 22b) is connected to an elongation-detection apparatus (24), and vice versa.

3. Method according to Claim 1 or 2, **characterized in that** at least one switching signal (A, B, C, D) is generated or specified, with which signal the at least one switching apparatus (34) is switched.

4. Method according to one of the preceding claims, **characterized in that** the connections between the at least one comb drive (22a, 22b), on the one hand, and the actuation apparatus (32) or the elongation-detection apparatus (24), on the other, are switched as a function of at least one elongation signal (P1, P2).

5. Method according to one of the preceding claims, **characterized in that** during a transient recovery time of the micro-oscillation mirror (16) at least one comb drive (22a, 22b) is alternately connected to an actuation branch (36a, 36b), allocated thereto, of the actuation apparatus (32), or, under certain circumstances, to an elongation-detection branch (38a, 38b), allocated to this comb drive (22a, 22b), of the elongation-detection apparatus (24).

6. Method according to one of the preceding claims, **characterized in that** at least one comb drive (22a, 22b) is actuated with at least one actuation signal (AS1, AS2) between two amplitudes of the oscillation of the micro-oscillation mirror (16).

7. Method according to one of the preceding claims, **characterized in that** at least one comb drive (22a, 22b) is actuated with at least one actuation signal (AS1, AS2) in a driving fashion until a measurement variable following the actuation signal (AS1, AS2) reaches a specifiable limiting value.

8. Method according to one of the preceding claims, **characterized in that** while at least one comb drive (22a, 22b) is actuated in a driving fashion with at least one actuation signal (AS1, AS2), an electric comb current (I1, I2) of the at least one comb drive (22a, 22b) is determined as a variable which characterizes a position of comb electrode structures of the at least one comb drive (22a, 22b).

9. Control device (28) for controlling at least one drive apparatus (20) of a micro-oscillation mirror (16), wherein the at least one drive apparatus (20) has at least two comb drives (22a, 22b) which are arranged on different radial sides of a pivoting axis (18) of the micro-oscillation mirror (16)
- having at least one actuation apparatus (32) configured to actuate the at least two comb drives (22a, 22b) using actuation signals (AS1, AS2),
- having at least one elongation-detection apparatus (24) configured to determine at least one elongation signal (P1, P2) which characterizes the elongation (26) of the micro-oscillation mirror (16),
- and having at least one apparatus (34) which is connected in a controllable fashion to the at least one actuation apparatus (32) such that at least one of the actuation signals (AS1, AS2) can be adapted to the oscillation frequency of the micro-oscillation mirror (16) on the basis of at least one of the elongation signals (P1, P2), and the control device (28) has at least one switching apparatus (34) configured, during a transient recovery time of the micro-oscillation mirror (16), to alternately connect at least one comb drive (22a, 22b) to the at least one actuation apparatus (32) or to the at least one elongation-detection apparatus (24),
**characterized in that**
the control apparatus (28) is further configured, after a transient recovery time of the micro-oscillation mirror (16), to use at least one of the comb drives (22a, 22b) exclusively to drive the micro-oscillation mirror (16) and to use at least one of the comb drives (22a, 22b) exclusively to detect the elongation (26) of the micro-oscillation mirror (16).

10. Control device according to Claim 9, **characterized in that** at least one switching apparatus (34) has at least one switch (40a, 40b, 42a, 42b) and the control device (28) has at least one switching signal-generating apparatus (33) with which at least one switching signal (A, B, C, D) for switching the at least one switch can be generated.

11. Deflector mirror apparatus (14) of an optical detection apparatus (12), having
- at least one micro-oscillation mirror (16),
- at least one drive apparatus (20) for the at least one micro-oscillation mirror (16), wherein the drive apparatus (20) has at least two comb drives (22a, 22b) which are arranged on different radial sides of a pivoting axis (18) of the micro-oscillation mirror (16), and
- a control device (28) according to Claim 9 or 10.

## Revendications

1. Procédé de commande d'un appareil d'entraînement (20) d'un micromiroir oscillant (16), l'appareil d'entraînement (20) présentant au moins deux entraînements à peigne (22a, 22b) qui sont agencés sur des côtés radiaux différents d'un axe de pivotement (18) du micromiroir oscillant (16), dans le procédé
- au moins deux signaux de commande (AS1, AS2) étant générés et les au moins deux entraînements à peigne (22a, 22b) étant ainsi commandés au moins temporairement de telle sorte qu'ils entraînent le micromiroir oscillant (16) de manière oscillante,
- au moins un signal d'élongation (P1, P2) caractérisant l'élongation (26) du micromiroir oscillant (16) étant généré à l'aide d'au moins un entraînement à peigne (22a, 22b),
- au moins l'un des signaux de commande (AS1, AS2) étant adapté à l'oscillation du micromiroir oscillant (16) sur la base d'au moins l'un des signaux d'élongation (P1, P2),
- pendant un temps d'oscillation du micromiroir oscillant (16), au moins l'un des entraînements à peigne (22a, 22b) étant relié alternativement, au moyen d'au moins un appareil de commutation (34), à un appareil de commande (32) pour recevoir au moins un signal de commande (AS1, AS2) ou à un appareil de détection d'élongation (24) pour générer au moins un signal d'élongation (P1, P2),
**caractérisé en ce que**
après un temps d'oscillation du micromiroir oscillant (16), au moins l'un des entraînements à peigne (22a, 22b) est utilisé exclusivement pour entraîner le micromiroir oscillant (16) et au moins l'un des entraînements à peigne (22a, 22b) est utilisé exclusivement pour détecter l'élongation (26) du micromiroir oscillant (16).

2. Procédé selon la revendication 1, **caractérisé en ce que,** pendant un temps d'oscillation du micromiroir oscillant (16), l'un des au moins deux entraînements à peigne (22a, 22b) est relié alternativement à un appareil de commande (32), tandis qu'un autre des au moins deux entraînements à peigne (22a, 22b) est relié à un appareil de détection d'élongation (24) et inversement.

3. Procédé selon la revendication 1 ou 2, **caractérisé en ce qu**'au moins un signal de commutation (A, B, C, D) est généré ou prédéfini, avec lequel l'au moins un appareil de commutation (34) est commuté.

4. Procédé selon l'une quelconque des revendications précédentes, **caractérisé en ce que** les liaisons entre l'au moins un entraînement à peigne (22a, 22b) d'une part et l'appareil de commande (32) ou l'appareil de détection d'élongation (24) d'autre part sont commutées en fonction d'au moins un signal d'élongation (P1, P2).

5. Procédé selon l'une quelconque des revendications précédentes, **caractérisé en ce que,** pendant un temps d'oscillation du micromiroir oscillant (16), au moins un entraînement à peigne (22a, 22b) est relié alternativement à une branche de commande (36a, 36b) de l'appareil de commande (32) qui lui est affectée ou, le cas échéant, à une branche de détection d'élongation (38a, 38b) de l'appareil de détection d'élongation (24) qui est affectée à cet entraînement à peigne (22a, 22b).

6. Procédé selon l'une quelconque des revendications précédentes, **caractérisé en ce qu**'au moins un entraînement à peigne (22a, 22b) est commandé entre deux amplitudes de l'oscillation du micromiroir oscillant (16) avec au moins un signal de commande (AS1, AS2).

7. Procédé selon l'une quelconque des revendications précédentes, **caractérisé en ce qu**'au moins un entraînement à peigne (22a, 22b) est commandé en entraînement avec au moins un signal de commande (AS1, AS2) jusqu'à ce qu'une grandeur de mesure suivant le signal de commande (AS1, AS2) atteigne une valeur limite prédéfinissable.

8. Procédé selon l'une quelconque des revendications précédentes, **caractérisé en ce que,** pendant qu'au moins un entraînement à peigne (22a, 22b) est commandé en entraînement avec au moins un signal de commande (AS1, AS2), un courant de peigne électrique (I1, I2) de l'au moins un entraînement à peigne (22a, 22b) est déterminé comme une grandeur qui caractérise une position de structures d'électrodes de peigne de l'au moins un entraînement à peigne (22a, 22b).

9. Dispositif de commande (28) pour commander au moins un appareil d'entraînement (20) d'un micromiroir oscillant (16), l'au moins un appareil d'entraînement (20) présentant au moins deux entraînements à peigne (22a, 22b) qui sont agencés sur des côtés radiaux différents d'un axe de pivotement (18) du micromiroir oscillant (16),
- avec au moins un appareil de commande (32) qui est conçu pour commander les au moins deux entraînements à peigne (22a, 22b) à l'aide de signaux de commande (AS1, AS2),
- avec au moins un appareil de détection d'élongation (24), qui est conçu pour déterminer au moins un signal d'élongation (P1, P2) caractérisant l'élongation (26) du micromiroir oscillant (16),
- et avec au moins un appareil (34) qui est relié de manière réglable à l'au moins un appareil de commande (32) de telle sorte qu'au moins l'un des signaux de commande (AS1, AS2) peut être adapté à la fréquence d'oscillation du micromiroir oscillant (16) sur la base d'au moins l'un des signaux d'élongation (P1, P2),
et
le dispositif de commande (28) présente au moins un appareil de commutation (34), qui est conçu pour, pendant un temps d'oscillation du micromiroir oscillant (16), relier au moins un entraînement à peigne (22a, 22b) alternativement avec l'au moins un appareil de commande (32) ou avec l'au moins un appareil de détection d'élongation (24),
**caractérisé en ce que**
le dispositif de commande (28) est en outre conçu pour, après un temps d'oscillation du micromiroir oscillant (16), utiliser au moins l'un des entraînements à peigne (22a, 22b) exclusivement pour entraîner le micromiroir oscillant (16) et au moins l'un des entraînements à peigne (22a, 22b) exclusivement pour détecter l'élongation (26) du micromiroir oscillant (16).

10. Dispositif de commande selon la revendication 9, **caractérisé en ce qu**'au moins un appareil de commutation (34) présente au moins un commutateur (40a, 40b, 42a, 42b) et le dispositif de commande (28) présente au moins un appareil de génération de signal de commutation (33) avec lequel au moins un signal de commutation (A, B, C, D) peut être généré pour commuter l'au moins un commutateur.

11. Appareil de miroir de renvoi (14) d'un dispositif de détection optique (12) avec
- au moins un micromiroir oscillant (16),
- au moins un appareil d'entraînement (20) pour l'au moins un micromiroir oscillant (16), l'appareil d'entraînement (20) présentant au moins deux entraînements à peigne (22a, 22b) qui sont agencées sur des côtés radiaux différents d'un axe de pivotement (18) du micromiroir oscillant (16), et
- un dispositif de commande (28) selon la revendication 9 ou 10.
